# EUROPÄISCHE PATENTSCHRIFT

(11) **EP 1 081 772 B1**
(45) Veröffentlichungstag und Bekanntmachung des Hinweises auf die Patenterteilung: **29.06.2005**
(21) Anmeldenummer: 00203000.5
(22) Anmeldetag: 29.08.2000
(51) Int. Cl.: H01L 41/09, B26B 19/28, G11B 7/085

(54) **Piezoelektrische Antriebsvorrichtung**
Piezoelectric driving device
Dispositif d'entraînement piézoélectrique

(30) Priorität: 04.09.1999 DE 19942269
(43) Veröffentlichungstag der Anmeldung: 07.03.2001
(73) Patentinhaber: Philips Intellectual Property & Standards GmbH, 20099 Hamburg (DE); Koninklijke Philips Electronics N.V., 5621 BA Eindhoven (NL)
(72) Erfinder: Morales Serrano, Francisco, 52064 Aachen (DE); Lauter, Josef, 52064 Aachen (DE); Reichinger, Christian, 52064 Aachen (DE)
(74) Vertreter: Volmer, Georg, Dipl.-Ing.

(56) Entgegenhaltungen:
- EP-A- 0 633 616
- US-A- 5 545 954
- KATO K ET AL: "ROBUST RESONANT FREQUENCY TRACKING CONTROL FOR ULTRASONIC-MOTOR DRIVE" ELECTRONICS & COMMUNICATIONS IN JAPAN, PART II - ELECTRONICS, SCRIPTA TECHNICA. NEW YORK, US, Bd. 80, Nr. 3, 1. März 1997 (1997-03-01), Seiten 1-11, XP000754673 ISSN: 8756-663X

## Beschreibung

Die Erfindung bezieht sich auf eine piezoelektrische Antriebsvorrichtung mit einem bimodalen piezoelektrischen Resonator,
mit wenigstens einer ersten Steuerelektrode zur Ansteuerung des Resonators in einer ersten Antriebsrichtung,
mit wenigstens einer zweiten Steuerelektrode zur Ansteuerung des Resonators in einer zweiten Antriebsrichtung und
mit einer Ansteuerschaltung zur Lieferung von Steuersignalen an die erste und die zweite Steuerelektrode.

Eine derartige piezoelektrische Antriebsvorrichtung ist aus der EP 633616 A2 bekannt. Diese bekannte Antriebsvorrichtung weist als piezoelektrischen Resonator eine rechteckförmige piezoelektrische Platte mit vier Steuerelektroden auf, wobei zwei Steuerelektroden zur Ansteuerung des Resonators in der ersten Antriebsrichtung und die anderen zwei Steuerelektroden zur Ansteuerung des Resonators in der zweiten Antriebsrichtung vorgesehen sind.

Es ist Aufgabe der Erfindung, eine Antriebsvorrichtung der eingangs genannten Art mit verbessertem Wirkungsgrad zu schaffen.

Diese Aufgabe ist erfindungsgemäß dadurch gelöst, dass
- eine Regelschaltung zur Regelung der Steuersignale vorgesehen ist
- dass bei Ansteuerung des Resonators in der ersten Antriebsrichtung mittels der ersten Steuerelektrode die zweite Steuerelektrode zur Lieferung eines Rückkopplungssignals an die Regelschaltung vorgesehen ist
- dass bei Ansteuerung des Resonators in der zweiten Antriebsrichtung mittels der zweiten Steuerelektrode die erste Steuerelektrode zur Lieferung eines Rückkopplungssignals an die Regelschaltung vorgesehen ist.

Eine derartige Antriebsvorrichtung kann mit einem hohen Wirkungsgrad realisiert werden. Für piezoelektrische Antriebsvorrichtungen mit hohem Wirkungsgrad ist es erforderlich, dass der piezoelektrische Resonator eine hohe Güte hat. Bei hohen Resonatorgüten ist der Verlauf der Güte über der Frequenz schmalbandig. Die optimale Frequenz, d.h. die Frequenz, bei der der Resonator die höchste Güte hat, ist beispielsweise von der Amplitude der den Steuerelektroden zugeführten Steuerspannung, der mechanischen Vorspannung des Resonators, von mechanischen Toleranzen im Aufbau und von Laständerungen abhängig. Mittels der Regelschaltung ist es möglich, das den Steuerelektroden zugeführte Steuersignal derart nachzuregeln, dass sich ständig ein optimaler Wirkungsgrad der Antriebsvorrichtung ergibt.

Zur Gewinnung des für die Regelung erforderlichen Rückkopplungssignals ist jeweils die passive Steuerelektrode vorgesehen, d.h. die Steuerelektrode, welche bei der jeweiligen Antriebsrichtung nicht angesteuert wird. Dies ermöglicht eine optimale Ausnutzung der Fläche des piezoelektrischen Resonators. Es sind keine zusätzliche Sensorelektroden zur Gewinnung des Rückkopplungssignals erforderlich. Zusätzliche Sensorelektroden würden die für die Steuerelektroden zur Verfügung stehende Fläche und damit das aktive Piezovolumen, d.h. das Volumen unterhalb der Steuerelektrodenflächen, reduzieren.

Bei der vorteilhaften Ausgestaltung der Erfindung nach Anspruch 2 sind ein erstes und ein zweites Steuerelektrodenpaar zur Ansteuerung der jeweiligen Antriebsrichtung vorgesehen. Das aktive Piezovolumen, d.h. das Volumen unterhalb der Steuerelektroden, soll so groß wie möglich sein, um eine hohe Energiedichte und eine maximale Ausgangsleistung zu erzielen. Die paarweise Anordnung der Steuerelektroden ermöglicht eine gute Platzausnutzung der Oberfläche des piezoelektrischen Resonators.

Insbesondere ist die paarweise Ausbildung der Steuerelektroden günstig bei der vorteilhaften Ausgestaltung der Erfindung gemäß Anspruch 3. Die im wesentlichen rechteckförmig ausgebildeten piezoelektrischen Resonatoren sind in Dickenrichtung polarisiert und die Schwingungsmoden werden vorzugsweise durch den D-31 Piezoeffekt stimuliert.

Die bei der vorteilhaften Ausgestaltung der Erfindung gemäß Anspruch 4 vorgesehene Auswertung der Amplitude erfolgt vorzugsweise mittels eines Analog-Digital Wandlers. Die Regelschaltung vergleicht entweder die Amplitude des Rückkopplungssignals mit einem vorgebbaren Referenzwert oder die Regelschaltung vergleicht die Amplitude des Rückkopplungssignals mit der Amplitude des Steuersignals und leitet daraus das Regelsignal ab.

Die vorteilhafte Ausgestaltung der Erfindung gemäß Anspruch 5 ist besonders einfach und kostengünstig realisierbar, da kein Analog-Digital Wandler erforderlich ist.

Die Regelung der Frequenz des Steuersignals gemäß der vorteilhaften Ausgestaltung der Erfindung nach Anspruch 6 ermöglicht es, den piezoelektrischen Resonator ständig bei der größtmöglichen Güte zu betreiben.

Die Regelung der Amplitude gemäß Anspruch 7 hat den Vorteil, dass man damit die Ausgangsleistung des Motors regeln kann.

Besonders vorteilhaft ist es, die Regelung der Frequenz und die Regelung der Amplitude zu kombinieren. Bei der vorteilhaften Ausgestaltung der Erfindung gemäß Anspruch 8 geschieht dies in einem ersten Schritt mittels Regelung der Frequenz des Steuersignals. Dies gewährleistet eine optimale Güte des piezoelektrischen Resonators. Vorteilhaft kann dann in einem zweiten Schritt noch die Amplitude des Steuersignals geregelt werden, z.B. um ein gewünschte Ausgangsleistung bzw. ein gewünschtes Drehmoment zu erzielen.

Die Antriebsvorrichtung kann vorzugsweise zum Antrieb des Scherkopfes eines Rasierers oder zum Antrieb der Schreib/Leseeinheit eines elektronischen Gerätes zum Lesen von auf plattenförmigen Datenträgern, insbesondere CDs und DVDs, gespeicherten Informationen und/oder zum Schreiben von Informationen auf plattenförmige Datenträger, verwendet werden.

Einige schematisch dargestellte Ausführungsbeispiele der Erfindung werden nachfolgend anhand der Zeichnung in den Figuren 1 bis 6 näher erläutert. Es zeigen:
- Fig. 1: eine perspektivische Ansicht eines piezoelektrischen Resonators mit vier Steuerelektroden, wobei die sich diagonal gegenüberliegenden Steuerelektroden jeweils paarweise einerseits mit einer Regelschaltung und andererseits mit einer Steuerschaltung koppelbar sind,
- Fig. 2: eine Seitenansicht des piezoelektrischen Resonators gemäß Fig. 2,
- Fig. 3: ein CD-Laufwerk mit einer piezoelektrischen Antriebsvorrichtung gemäß Fig. 1,
- Fig. 4: eine weitere Ausführungsform eines CD-Laufwerks mit einer piezoelektrischen Antriebsvorrichtung gemäß Fig. 1 und
- Fig. 5: eine dritte Ausführungsform eines CD-Laufwerks mit einer piezoelektrischen Antriebsvorrichtung gemäß Fig. 1.
- Fig. 6: eine prinzipielle Skizze eines Barttrimmers eines Rasierers, angetrieben mittels einer piezoelektrischen Antriebsvorrichtung gemäß Fig. 1.

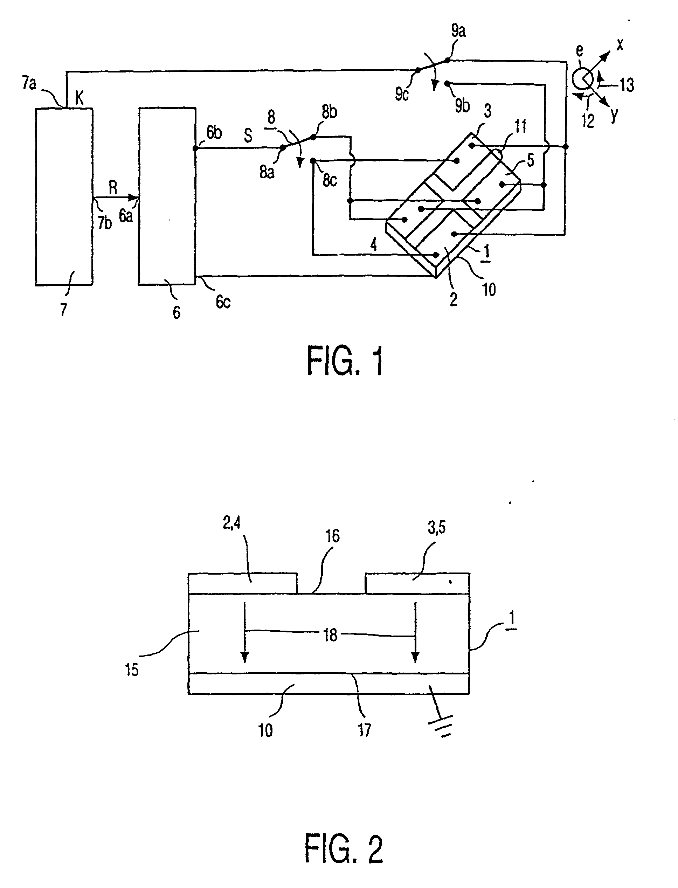

Fig. 1 zeigt in perspektivischer Ansicht einen im wesentlichen rechteckförmigen piezoelektrischen Resonator 1, welcher eine erste Steuerelektrode 2, eine zweite Steuerelektrode 3, eine dritte Steuerelektrode 4 und eine vierte Steuerelektrode 5 aufweist. Die erste Steuerelektrode 2 und die zweite Steuerelektrode 3 sind diagonal gegenüberliegend angeordnet und bilden ein erstes Steuerelektrodenpaar. Die dritte Steuerelektrode 4 und die vierte Steuerelektrode 5 sind ebenfalls diagonal gegenüberliegend angeordnet und bilden ein zweites Steuerelektrodenpaar. Zur Ansteuerung des piezoelektrischen Resonators 1 ist eine Ansteuerschaltung 6 vorgesehen. Die Ansteuerschaltung 6 liefert ein Steuersignal S an den piezoelektrischen Resonator 1. Zur Regelung der Steuersignale S der Ansteuerschaltung 6 ist eine Regelschaltung 7 vorgesehen. Zwischen der Ansteuerschaltung 6 und dem piezoelektrischen Resonator 1 ist ein erster Schalter 8 angeordnet. Die Ansteuerschaltung 6 weist einen Ausgang 6b auf; welcher mit einem Eingang 8a des ersten Schalters 8 gekoppelt ist. Dem ersten Schalter 8 wird an seinem Eingang 8a das Steuersignal S zugeführt. Ausgangsseitig weist der erste Schalter 8 eine erste Schaltstellung 8b und eine zweite Schaltstellung 8c auf. Die erste Schaltstellung 8b ist mit der dritten Steuerelektrode 4 und der vierten Steuerelektrode 5 gekoppelt. Die zweite Schaltstellung 8c ist mit der ersten Steuerelektrode 2 und der zweiten Steuerelektrode 3 gekoppelt. Zwischen dem piezoelektrischen Resonator 1 und der Regelschaltung 7 ist ein zweiter Schalter 9 angeordnet. Der zweite Schalter 9 weist eingangsseitig eine erste Schaltstellung 9a und eine zweite Schaltstellung 9b auf. Der zweite Schalter 9 weist einen Ausgang 9c auf, welcher mit einem Eingang 7a der Regelschaltung 7 gekoppelt ist. Die erste Schaltstellung 9a des zweiten Schalters 9 ist mit der ersten Steuerelektrode 2 und der zweiten Steuerelektrode 3 gekoppelt. Die zweite Schaltstellung 9b des zweiten Schalters 9 ist mit der dritten Steuerelektrode 4 und der vierten Steuerelektrode 5 gekoppelt. Der piezoelektrische Resonator 1 weist auf seiner Unterseite eine ganzflächige Masseelektrode 10 auf. Die Ansteuerschaltung 6 weist einen Masseausgang 6c auf welcher mit der Masseelektrode 10 des piezoelektrischen Resonators 1 gekoppelt ist. Die Regelschaltung 7 weist einen Ausgang 7b auf, welcher mit einem Eingang 6a der Ansteuerschaltung 6 gekoppelt ist.

Der piezoelektrische Resonator 1 weist an seiner Stirnseite einen Antriebsstößel 11 auf. Mittels dieses Antriebsstößels 11 kann der piezoelektrische Resonator 1 zum Antrieb von in der Figur 1 nicht näher dargestellten Antriebselementen verwendet werden, z.B. zum Antrieb des Scherkopfes eines elektrischen Rasierers. Der piezoelektrische Resonator 1 kann in einer Schwingungsebene (x/y-Ebene) zu Schwingungen angeregt werden, wobei die Schwingung sich als Überlagerung zweier orthogonaler Schwingungen in x- und y-Richtung ergibt. Durch geeignete Ansteuerung und durch geeignete Wahl der Geometrie des piezoelektrischen Resonators 1 können die Resonanzfrequenzen der beiden orthogonalen Schwingungen so eingestellt werden, dass beide Schwingungen mit ausreichender Amplitude und gewünschter Phasenlage angeregt werden und dass der Antriebsstößel 11 des piezoelektrischen Resonators 1 sich auf einer in der x/y-Ebene liegenden Kurve, insbesondere einer ellipsenförmigen Kurve e, bewegt. Durch geeignete Ansteuerung des piezoelektrischen Resonators 1 kann eine derartige Schwingung entlang der ellipsenförmigen Kurve e sowohl entgegen dem Uhrzeigersinn in einer ersten Antriebsrichtung 12 als auch im Uhrzeigersinn in einer zweiten Antriebsrichtung 13 angeregt werden. Zur Ansteuerung des piezoelektrischen Resonators in der ersten Antriebsrichtung 12 sind die erste Steuerelektrode 2 und die zweite Steuerelektrode 3 vorgesehen. Zur Ansteuerung des piezoelektrischen Resonators 1 in der zweiten Antriebsrichtung 13 sind die dritte Steuerelektrode 4 und die vierte Steuerelektrode 5 vorgesehen.

Zur Ansteuerung des piezoelektrischen Resonators 1 in der zweiten Antriebsrichtung 13 befindet sich der erste Schalter 8 in der in der Figur 1 dargestellten ersten Schaltstellung 8b und der zweite Schalter 9 befindet sich in der in der Figur 1 dargestellten ersten Schaltstellung 9a. Für diese zweite Antriebsrichtung 13 wird das Steuersignal S von der Ansteuerschaltung 6 über den sich in der ersten Schaltstellung 8b befindenden Schalter 8 parallel sowohl der dritten Steuerelektrode 4 als auch der vierten Steuerelektrode 5 zugeführt. Dieses Steuersignal S regt den piezoelektrischen Resonator 1 derart an, dass er sich in der zweiten Antriebsrichtung 13 bewegt. Für diese zweite Antriebsrichtung 13 sind die erste Steuerelektrode 2 und die zweite Steuerelektrode 3 über den sich in der ersten Schaltstellung 9a befindenden zweiten Schalter 9 mit dem Eingang 7a der Regelschaltung 7 verbunden. Die erste Steuerelektrode 2 und die zweite Steuerelektrode 3 liefern somit ein Rückkopplungssignal K an die Regelschaltung 7. Das Rückkopplungssignal K liefert der Regelschaltung 7 eine Zustandsbeschreibung der Schwingung des piezoelektrischen Resonators 1. Die Regelschaltung 7 wertet das Rückkopplungssignal K aus und liefert ein Regelsignal R an die Steuerschaltung 6. Mittels dieses Regelsignals R wird das von der Steuerschaltung 6 an den piezoelektrischen Resonator 1 gelieferte Steuersignal S geregelt.

Die Regelschaltung 7 ist entweder zur Auswertung der Amplitude des Rückkopplungssignals K oder zur Auswertung der Phasendifferenz zwischen dem Steuersignal S und dem Rückkopplungssignal K vorgesehen. Zur Auswertung der Amplitude des Rückkopplungssignals K ist es erforderlich, dass die Regelschaltung 7 einen Analog-Digital-Wandler auf weist. Zur Auswertung der Phasendifferenz zwischen dem Steuersignal S und dem Rückkopplungssignal K weist die Regelschaltung 7 einen Phasendetektor auf Ein derartiger Phasendetektor ist besonders einfach und kostengünstig zu realisieren.

Das von der Regelschaltung 7 gelieferte Regelsignal R kann zur Regelung der Frequenz des Steuersignals S, zur Regelung der Amplitude des Steuersignals S oder zur Regelung der Frequenz und der Amplitude des Steuersignals S verwendet werden.

Zur Ansteuerung des piezoelektrischen Resonators 1 in der ersten Antriebsrichtung 12 befindet sich der erste Schalter 8 in der zweiten Schaltstellung 8c und der zweite Schalter 9 befindet sich in der zweiten Schaltstellung 9b. Die Steuerschaltung 6 liefert zur Ansteuerung des piezoelektrischen Resonators in der ersten Antriebsrichtung 12 das Steuersignal S an die erste Steuerelektrode 2 und an die zweite Steuerelektrode 3. Bei Betrieb in der Antriebsrichtung 12 sind die dritte Steuerelektrode 4 und die vierte Steuerelektrode 5 zur Lieferung des Rückkopplungssignals K an die Regelschaltung 7 vorgesehen. Diese liefert wiederum ein Regelsignal R an die Steuerschaltung 6, so dass auch in der ersten Antriebsrichtung 12 eine Regelung des Steuersignals S ermöglicht wird.

Mittels der Regelung des Steuersignals S und der damit verbundenen Regelung der Schwingung des piezoelektrischen Resonators 1 wird es möglich, den piezoelektrischen Resonator 1 immer bei der optimalen Frequenz, d.h. bei der Frequenz, bei der der Wirkungsgrad optimal ist, zu betreiben. Dies ist insbesondere vorteilhaft für piezoelektrische Resonatoren 1 mit hoher Schwingungsgüte, da bei derartigen Resonatoren der Verlauf der Güte über der Frequenz sehr schmalbandig verläuft. Durch Nachregelung der Frequenz des Steuersignals S kann daher ständig ein optimaler Betrieb der Antriebsvorrichtung bei der größtmöglichen Resonatorgüte gewährleistet werden.

In der ersten Antriebsrichtung 12 werden die passiven, d.h. nicht zur Ansteuerung des piezoelektrischen Resonators 1 vorgesehenen Steuerelektroden 4 und 5 zur Gewinnung des Rückkopplungssignals K genutzt. In der zweiten Antriebsrichtung 13 werden die für diese Antriebsrichtung passiven Steuerelektroden 2 und 3 zur Gewinnung des Rückkopplungssignals K genutzt. Diese wechselseitige Nutzung der Steuerelektroden einerseits zur aktiven Ansteuerung des Resonators 1 und andererseits zur passiven Gewinnung des Rückkopplungssignals K ermöglicht eine besonders effiziente Nutzung und Aufteilung der Fläche des piezoelektrischen Resonators 1. Bei einer derartigen Anordnung sind keine zusätzlichen Sensorelektroden zur Gewinnung des Rückkopplungssignals erforderlich. Daher wird das aktive Piezovolumen, d.h. das sich unter den jeweils aktiven Steuerelektroden befindliche Volumen, nicht durch zusätzliche Sensorelektroden verringert. Die Antriebsvorrichtung ist auch daher besonders effizient.

Fig. 2 zeigt den piezoelektrischen Resonator gemäß Fig. 1 in Seitenansicht. Der piezoelektrische Resonator 1 weist einen piezoelektrischen Grundkörper 15 mit einer ersten Oberfläche 16 und einer zweiten Oberfläche 17 auf. Die zweite Oberfläche 17 ist vollständig mit der Masseelektrode 10 bedeckt. Die erste Oberfläche 16 trägt die erste Steuerelektrode 2, die zweite Steuerelektrode 3, die dritte Steuerelektrode 4 und die vierte Steuerelektrode 5. Die Polarisierungsrichtung des piezoelektrischen Grundkörpers 15 ist unter den Steuerelektroden 2, 3, 4 und 5 gleich. In Fig. 2 ist die Polarisierungsrichtung durch zwei Pfeile 18 angedeutet. Die Schwingungsmoden des piezoelektrischen Resonators 1 werden durch den D 31-Piezoeffekt stimuliert.

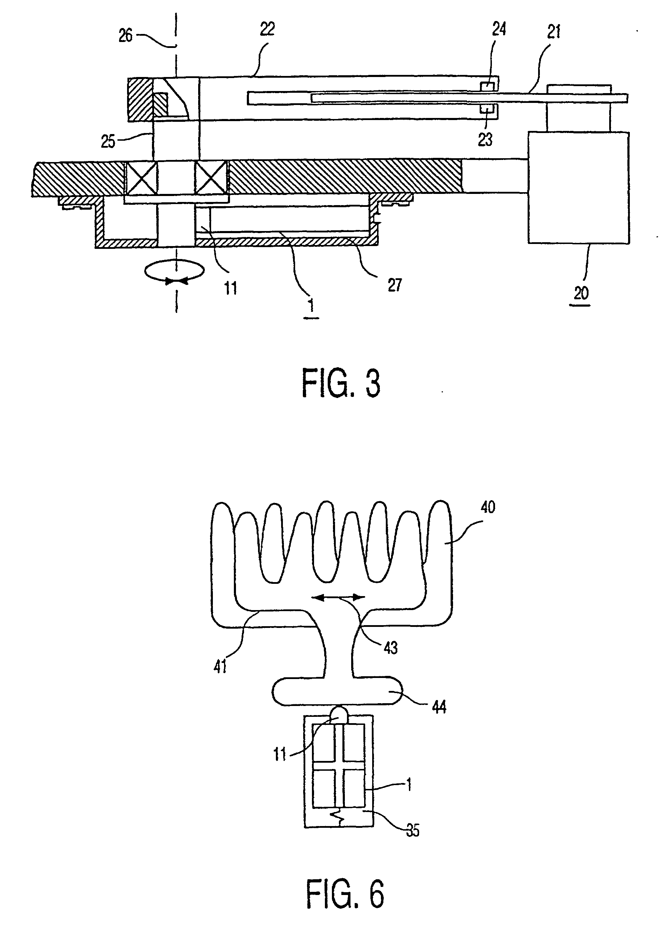

Fig. 3 zeigt ein CD-Laufwerk mit einer piezoelektrischen Antriebsvorrichtung gemäß Fig. 1. Bei diesem Laufwerk wird ein mit einem Lese-/Schreibkopf 23, 24 versehener Arm 22 in radialer Richtung über eine CD 21 bewegt, welche von einem Motor 20 angetrieben ist. Der Arm 22 ist auf einer um eine Drehachse 26 drehbaren Welle 25 angeordnet, die von einer piezoelektrischen Antriebsvorrichtung gemäß Fig. 1 angetrieben wird. Hierzu ist der piezoelektrische Resonator 1 in einem Gehäuse 27 angeordnet, welches gegen die Welle 25 vorgespannt ist. Mittels des Antriebsstößels 11 wird eine Kraft auf die Welle 25 übertragen, welche dadurch je nach Ansteuerung des piezoelektrischen Resonators 1 in beiden Drehrichtungen drehbar ist, so dass sich der Arm 22 in der gewünschten Richtung über die CD 21 bewegt.

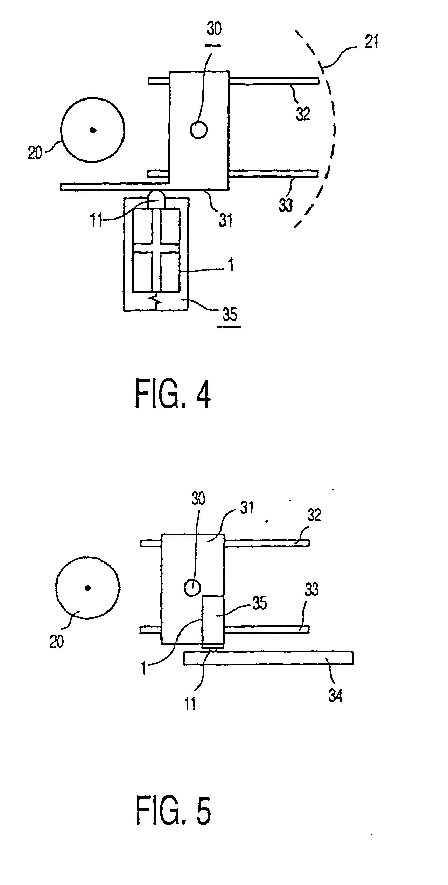

Fig. 4 zeigt eine weitere Ausführungsform eines CD-Laufwerks mit einer piezoelektrischen Antriebsvorrichtung 35. Dabei ist der Lese-/Schreibkopf hinter einer Linse 30 verborgen. Die gesamte Lese-/Schreibeinheit ist auf einem Schlitten 31 untergebracht und wird mittels der piezoelektrischen Antriebsvorrichtung 35 entlang zweier Führungen 32, 33 linear in radialer Richtung der CD 21 bewegt. Dabei kann das piezoelektrische Antriebselement 35 fest im Gehäuse des CD-Laufwerks eingebaut sein und mittels des Antriebsstößels 11 gegen den Schlitten 31 stoßen und diesen bewegen.

Eine weitere Ausführungsform ist in der Fig. 5 dargestellt, bei der die piezoelektrische Antriebseinheit 35 auf dem Schlitten 31 angebracht ist. Der Antriebsstößel 11 stößt gegen das Laufwerksgehäuse 34. Dadurch bewegen sich die piezoelektrische Antriebsvorrichtung 35 und der Schlitten 31 gemeinsam.

Fig. 6 zeigt eine prinzipielle Skizze eines Barttrimmers eines Rasierers. Der Barttrimmer, welcher insbesondere zum Schneiden langer Haare vorgesehen ist, weist einen feststehenden Kamm 40 und einen beweglichen Kamm 41 auf. Der bewegliche Kamm 41 ist mittels der piezoelektrischen Antriebvorrichtung 35 oszillierend in Richtung des Doppelpfeils 43 antreibbar. Der bewegliche Kamm 41 weist vorzugsweise ein T-förmiges Ansatzstück 44 auf, gegen welches der Antriebsstößel 11 stößt.

Die Ansteuerung und Regelung des piezoelektrischen Resonators 1 ist in den Figuren 2 bis 6 aus Übersichtlichkeitsgründen nicht dargestellt.

## Patentansprüche

1. Piezoelektrische Antriebsvorrichtung mit einem bimodalen piezoelektrischen Resonator (1),
mit wenigstens einer ersten Steuerelektrode (2) zur Ansteuerung des Resonators (1) in einer ersten Antriebsrichtung,
mit wenigstens einer zweiten Steuerelektrode (3) zur Ansteuerung des Resonators (1) in einer zweiten Antriebsrichtung und
mit einer Ansteuerschaltung (6) zur Lieferung von Steuersignalen (S) an die erste und die zweite Steuerelektrode
**dadurch gekennzeichnet,**
- **dass** eine Regelschaltung (7) zur Regelung der Steuersignale (S) vorgesehen ist
- **dass** bei Ansteuerung des Resonators (1) in der ersten Antriebsrichtung mittels der ersten Steuerelektrode (2) die zweite Steuerelektrode (3) zur Lieferung eines Rückkopplungssignals (K) an die Regelschaltung (7) vorgesehen ist
- **dass** bei Ansteuerung des Resonators (1) in der zweiten Antriebsrichtung mittels der zweiten Steuerelektrode (3) die erste Steuerelektrode (2) zur Lieferung eines Rückkopplungssignals (K) an die Regelschaltung (7) vorgesehen ist.

2. Piezoelektrische Antriebsvorrichtung nach Anspruch 1,
**dadurch gekennzeichnet,**
- **dass** der piezoelektrische Resonator (1) ein erstes Steuerelektrodenpaar (2, 3) zur Ansteuerung des Resonators in der ersten Antriebsrichtung und ein zweites Steuerelektrodenpaar (4, 5) zur Ansteuerung des Resonators (1) in der zweiten Antriebsrichtung aufweist,
- **dass** bei Ansteuerung des Resonators (1) in der ersten Antriebsrichtung mittels des ersten Steuerelektrodenpaars (2, 3) das zweite Steuerelektrodenpaar (4, 5) zur Lieferung eines Rückkopplungssignals (K) an die Regelschaltung (7) vorgesehen ist
- **dass** bei Ansteuerung des Resonators (1) in der zweiten Antriebsrichtung mittels des zweiten Steuerelektrodenpaars (4, 5) das erste Steuerelektrodenpaar (2, 3) zur Lieferung eines Rückkopplungssignals (K) an die Regelschaltung (7) vorgesehen ist.

3. Piezoelektrische Antriebsvorrichtung nach Anspruch 1,
**dadurch gekennzeichnet,**
**dass** der piezoelektrische Resonator (1) im wesentlichen rechteckförmig ausgebildet ist und dass jeweils eine Steuerelektrode in jedem Quadranten des im wesentlichen rechteckförmig ausgebildeten piezoelektrischen Resonators (1) vorgesehen ist.

4. Piezoelektrische Antriebsvorrichtung nach Anspruch 1,
**dadurch gekennzeichnet,**
**dass** die Regelschaltung (7) zur Auswertung der Amplitude des Rückkopplungssignals (K) vorgesehen ist.

5. Piezoelektrische Antriebsvorrichtung nach Anspruch 1,
**dadurch gekennzeichnet,**
**dass** die Regelschaltung (7) zur Auswertung der Phasendifferenz zwischen dem Steuersignal (S) und dem Rückkopplungssignal (K) mittels einer Phasenregelschaltung (PLL) vorgesehen ist.

6. Piezoelektrische Antriebsvorrichtung nach Anspruch 1,
**dadurch gekennzeichnet,**
**dass** die Regelschaltung (7) zur Regelung der Frequenz des Steuersignals (S) vorgesehen ist.

7. Piezoelektrische Antriebsvorrichtung nach Anspruch 1,
**dadurch gekennzeichnet,**
**dass** die Regelschaltung (7) zur Regelung der Amplitude des Steuersignals vorgesehen ist.

8. Piezoelektrische Antriebsvorrichtung nach Anspruch 1,
**dadurch gekennzeichnet,**
**dass** die Regelschaltung (7) in einem ersten Schritt zur Regelung der Frequenz des Steuersignals (S) vorgesehen ist und in einem zweiten Schritt zur Regelung der Amplitude des Steuersignals (S) vorgesehen ist.

9. Elektrischer Rasierer mit einem rotierenden und/oder oszillierenden Scherkopf,
**dadurch gekennzeichnet,**
**dass** der Rasierer zum Antrieb des Scherkopfs eine piezoelektrische Antriebsvorrichtung nach Anspruch 1 aufweist.

10. Elektronisches Gerät zum Lesen von auf plattenförmigen Datenträgern, insbesondere CDs und DVDs, gespeicherten Informationen und/oder zum Schreiben von Informationen auf plattenförmige Datenträger mittels einer Schreib/Leseeinheit,
**dadurch gekennzeichnet,**
**dass** das elektronische Gerät eine piezoelektrische Antriebsvorrichtung nach Anspruch 1 zum Antrieb der Schreib/Leseeinheit aufweist.

## Claims

1. A piezoelectric drive device with a bimodal piezoelectric resonator (1),
with at least a first control electrode (2) for triggering the resonator (1) in a first drive direction,
with at least a second control electrode (3) for triggering the resonator in a second drive direction, and
with a trigger circuit (6) for supplying control signals (S) to the first and the second control electrode,
**characterized in that**
- a regulating circuit (7) is provided for regulating the control signals (S),
- the second control electrode (3) is designed for supplying a feedback signal (K) to the regulating circuit (7) when the resonator (1) is being triggered in the first drive direction by means of the first control electrode (2), and
- the first control electrode (2) is designed for supplying a feedback signal (K) to the regulating circuit (7) when the resonator (1) is being triggered in the second drive direction by means of the second control electrode (3).

2. A piezoelectric drive device as claimed in claim 1,
**characterized in that**
- the piezoelectric resonator (1) comprises a first pair of control electrodes (2,3) for triggering the resonator in the first drive direction, and a second pair of control electrodes (4,5) for triggering the resonator in the second drive direction,
- the second pair of control electrodes (4,5) is designed for supplying a feedback signal (K) to the regulating circuit (7) when the resonator (1) is being triggered in the first drive direction by the first pair of control electrodes (2,3), and
- the first pair of control electrodes (2,3) is designed for supplying a feedback signal (K) to the regulating circuit (7) when the resonator (1) is being triggered in the second drive direction by the second pair of control electrodes (4,5).

3. A piezoelectric drive device as claimed in claim 1, **characterized in that** the piezoelectric resonator (1) is substantially rectangular in shape, and **in that** one control electrode is provided in each quadrant of the substantially rectangular piezoelectric resonator (1).

4. A piezoelectric drive device as claimed in claim 1, **characterized in that** the regulating circuit (7) is designed for evaluating the amplitude of the feedback signal (K).

5. A piezoelectric drive device as claimed in claim 1, **characterized in that** the regulating circuit (7) is designed for evaluating the phase difference between the control signal (S) and the feedback signal (K) by means of a phase control (PLL) circuit.

6. A piezoelectric drive device as claimed in claim 1, **characterized in that** the regulating circuit (7) is designed for regulating the frequency of the control signal (S).

7. A piezoelectric drive device as claimed in claim 1, **characterized in that** the regulating circuit (7) is designed for regulating the amplitude of the control signal (S).

8. A piezoelectric drive device as claimed in claim 1, **characterized in that** the regulating circuit (7) is designed for regulating the frequency of the control signal (S) in a first step, and for regulating the amplitude of the control signal (S) in a second step.

9. An electric shaver with a rotating and/or oscillating shaving head, **characterized in that** the shaver comprises a piezoelectric drive device as claimed in claim 1 for driving the shaving head.

10. An electronic device for reading data stored on disc-type data carriers, in particular CDs and DVDs, and/or for writing data on disc-type data carriers by means of a write/read unit, **characterized in that** the electronic device comprises a piezoelectric drive device as claimed in claim 1 for driving the write/read unit.

## Revendications

1. Dispositif d'entraînement piézoélectrique doté d'un résonateur piézoélectrique bimodal (1),
avec au moins une première électrode de commande (2) pour la commande du résonateur (1) dans une première direction d'entraînement,
avec au moins une deuxième électrode de commande (3) pour la commande du résonateur (1) dans une deuxième direction d'entraînement et
avec un circuit de commande (6) pour la délivrance de signaux de commande (S) aux première et deuxième électrodes de commande
**caractérisé en ce**
- **qu'**un circuit de réglage (7) est prévu pour le réglage des signaux de commande (S),
- **qu'**en cas de commande du résonateur (1) dans la première direction d'entraînement à l'aide de la première électrode de commande (2), la deuxième électrode de commande (3) est prévue pour la délivrance d'un signal de rétroaction (K) au circuit de réglage (7),
- **qu'**en cas de commande du résonateur (1) dans la deuxième direction d'entraînement à l'aide de la deuxième électrode de commande (3), la première électrode de commande (2) est prévue pour la délivrance d'un signal de rétroaction (K) au circuit de réglage (7).

2. Dispositif d'entraînement piézoélectrique selon la revendication 1,
**caractérisé en ce**
- **que** le résonateur piézoélectrique (1) présente une première paire d'électrodes de commande (2, 3) pour la commande du résonateur dans la première direction d'entraînement et
une deuxième paire d'électrodes de commande (4, 5) pour la commande du résonateur (1) dans la deuxième direction d'entraînement,
- **qu'**en cas de commande du résonateur (1) dans la première direction d'entraînement à l'aide de la première paire d'électrodes de commande (2, 3), la deuxième paire d'électrodes de commande (4, 5) est prévue pour la délivrance d'un signal de rétroaction (K) au circuit de réglage (7),
- **qu'**en cas de commande du résonateur (1) dans la deuxième direction d'entraînement à l'aide de la deuxième paire d'électrodes de commande (4, 5), la première paire d'électrodes de commande (2, 3) est prévue pour la délivrance d'un signal de rétroaction (K) au circuit de réglage (7).

3. Dispositif d'entraînement piézoélectrique selon la revendication 1,
**caractérisé en ce**
**que** le résonateur piézoélectrique (1) est de conception essentiellement rectangulaire et qu'une électrode de commande est respectivement prévue dans chaque quadrant du résonateur piézoélectrique (1) de conception essentiellement rectangulaire.

4. Dispositif d'entraînement piézoélectrique selon la revendication 1,
**caractérisé en ce**
**que** le circuit de réglage (7) est prévu pour l'évaluation de l'amplitude du signal de rétroaction (K).

5. Dispositif d'entraînement piézoélectrique selon la revendication 1,
**caractérisé en ce**
**que** le circuit de réglage (7) est prévu pour l'évaluation de la différence de phase entre le signal de commande (S) et le signal de rétroaction (K) à l'aide d'un circuit de réglage de phase (PLL).

6. Dispositif d'entraînement piézoélectrique selon la revendication 1,
**caractérisé en ce**
**que** le circuit de réglage (7) est prévu pour le réglage de la fréquence du signal de commande (S).

7. Dispositif d'entraînement piézoélectrique selon la revendication 1,
**caractérisé en ce**
**que** le circuit de réglage (7) est prévu pour le réglage de l'amplitude du signal de commande.

8. Dispositif d'entraînement piézoélectrique selon la revendication 1,
**caractérisé en ce**
**que** le circuit de réglage (7) est prévu dans une première étape pour le réglage de la fréquence du signal de commande (S) et dans une deuxième étape pour le réglage de l'amplitude du signal de commande (S).

9. Rasoir électrique avec une tête de rasage rotative et/ou oscillante,
**caractérisé en ce**
**que** le rasoir présente un dispositif d'entraînement piézoélectrique selon la revendication 1 pour l'entraînement de la tête de rasage.

10. Appareil électronique de lecture d'informations enregistrées sur des supports de données en forme de disque, en particulier des CD et des DVD, et/ou d'écriture d'informations sur des supports de données en forme de disque, à l'aide d'une unité d'écriture/lecture,
**caractérisé en ce**
**que** l'appareil électronique présente un dispositif d'entraînement piézoélectrique selon la revendication 1 pour l'entraînement de l'unité d'écriture/lecture.
